# EUROPEAN PATENT SPECIFICATION

(11) **EP 0 608 829 B1**
(45) Date of publication and mention of the grant of the patent: **17.05.2000**
(21) Application number: 94101052.2
(22) Date of filing: 25.01.1994
(51) Int. Cl.: G11C 8/00

(54) **Semiconductor memory apparatus having a plurality of word line drive circuits**
Halbleiterspeicheranordnung mit einer Vielzahl von Wortleitungstreiberschaltungen
Appareil de mémoire à semi-conducteurs ayant une pluralité de circuits d'attaque de ligne de mots

(30) Priority: 25.01.1993 JP 990493
(43) Date of publication of application: 03.08.1994
(73) Proprietor: KABUSHIKI KAISHA TOSHIBA, Kawasaki-shi, Kanagawa-ken 210-8572 (JP); TOSHIBA MICRO-ELECTRONICS CORPORATION, Kawasaki-ku, Kawasaki-shi, Kanagawa-ken (JP)
(72) Inventor: Shimizu, Mitsuru, c/o Intellectual Property Div., Minato-ku, Tokyo 105 (JP)
(74) Representative: Ritter und Edler von Fischern, Bernhard, Dipl.-Ing.

(56) References cited:
- EP-A- 0 284 102
- WO-A-86/02182
- IEEE INTERNATIONAL SOLID STATE CIRCUITS CONFERENCE., vol.27, no.31, 22 February 1984, NEW YORK US pages 278 - 279 KUNG E.A. 'A SUB 100NS 256K DRAM IN CMOS III TECHNOLOGY'
- IBM TECHNICAL DISCLOSURE BULLETIN., vol.31, no.12, May 1989, NEW YORK US pages 107 - 108, XP51987 'EFFICIENT USE OF REDUNDANT BIT LINES FOR YELD OPTIMIZATION'

## Description

The present invention relates to a semiconductor memory apparatus, e.g., a dynamic RAM (DRAM) and, more particularly, to a method of driving a word line.

A semiconductor memory generally comprises a block which is constituted by regularly repetitive identical patterns such as memory cells and a block which is constituted by irregularly repetitive patterns such as peripheral circuits for accessing the memory cells.

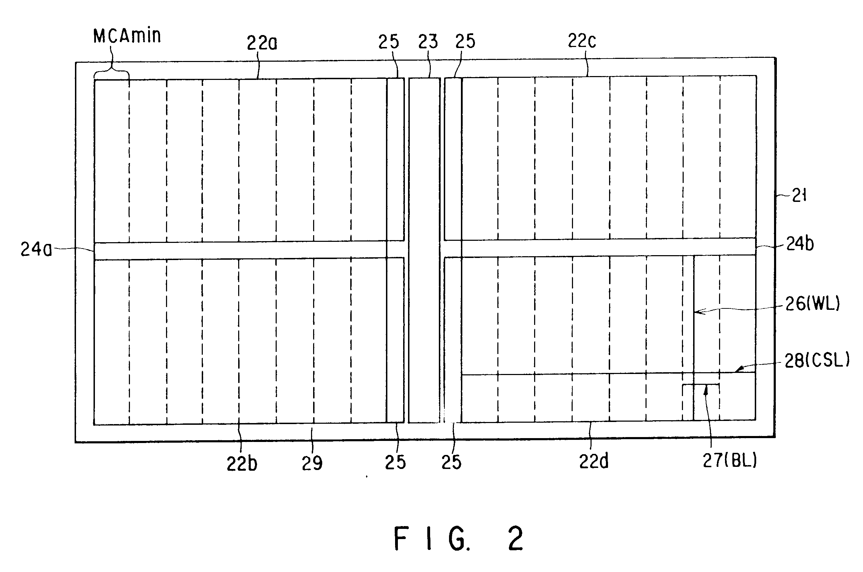

FIG. 2 shows the layout of a DRAM. Memory cell arrays 22a, 22b, 22c, and 22d constituted by regularly repetitive patterns are arranged at the central portion of a semiconductor chip 21. A peripheral circuit 23 constituted by irregularly repetitive patterns is arranged between the memory cell arrays 22a and 22b and the memory cell arrays 22c and 22d. In addition, a peripheral circuit 24a including a row decoder (to be referred to as an "RDC" hereinafter) is arranged between the memory cell arrays 22a and 22b, and a peripheral circuit 24b including an RDC is arranged between the memory cell arrays 22c and 22d. In this DRAM, the peripheral circuit 24a including the RDC is commonly used for the adjacent memory cell arrays 22a and 22b, and the peripheral circuit 24b is commonly used for the adjacent memory cell arrays 22c and 22d.

In addition, peripheral circuits 25 each including a column decoder are arranged between the peripheral circuit 23 and the memory cell arrays 22a and 22d, respectively. In addition, bonding pads (not shown), an input protecting circuit therefor, and a peripheral circuit 29 constituted by irregularly repetitive patterns are arranged at the peripheral portion of the semiconductor chip 21.

Each of the memory cell arrays 22a to 22b is divided into 2ⁿ or 2n (n is a natural number) areas as indicated by dotted lines, and each area partitioned by the dotted lines constitutes a minimum memory cell array MCAmin. Referring to FIG. 2, each of the memory cell arrays 22a to 22d is divided into 8 areas and has 8 minimum memory cell arrays MCAmin. A plurality of word lines (WL) 26 are arranged in each memory cell array MCAmin in the row direction, and a plurality of bit lines (BL) 27 are arranged in each memory cell array MCAmin in the column direction. A plurality of column selection lines (CSL) connected to the column decoder are arranged on the area of the memory cell arrays parallelly to the bit lines 27.

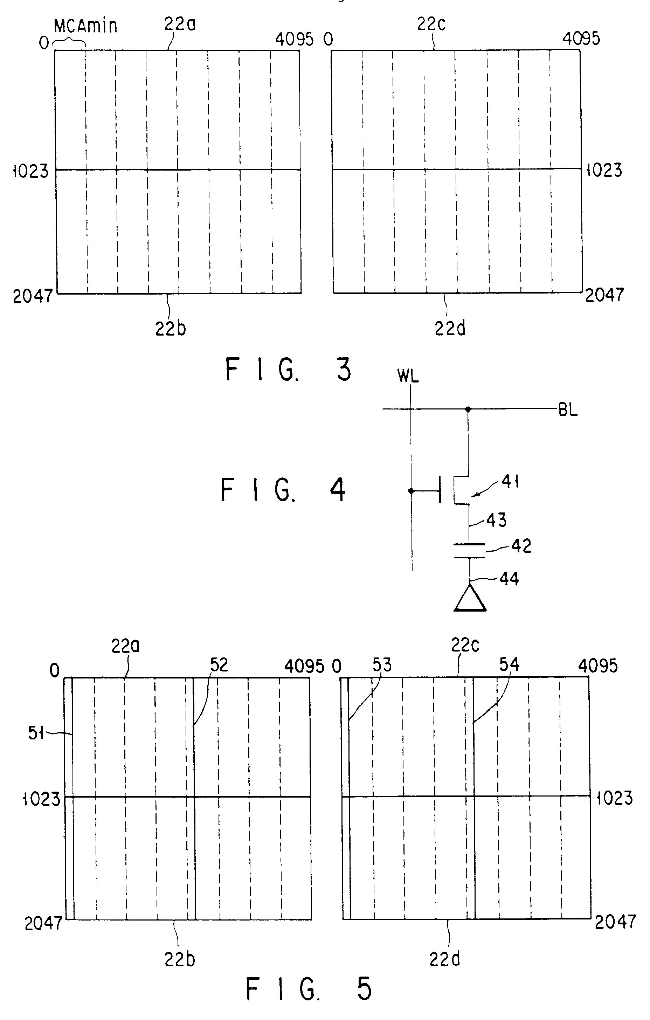

In order to understand a bit image from a pattern layout, assume that the chip layout shown in FIG. 2 has a 16-Mbit capacity. FIG. 3 is a map obtained by expressing the chip layout in FIG. 2 as a physical image.

The 4096 word lines 26 are arranged in each of the memory cell arrays 22a to 22d in the row direction. Therefore, 512 word lines are present in each minimum memory cell array MCAmin. On the other hand, bit lines, more accurately, 1024 pairs of bit lines, are arranged in each of the memory cell arrays 22a to 22d in the column direction. Since memory cells are respectively arranged on intersections between the word lines and the bit lines, it is understood that the memory cells have a 16-Mbit capacity.

An actual process of selecting a word line to access data will be described below. When simple read or write access is to be performed, one word line is selected, and data may be accessed from the bit lines crossing the selected word line. However, since a refresh operation is required for a DRAM, it is not necessarily satisfied that only one word line is selected.

Therefore, a memory cell of the DRAM is shown in FIG. 4, and the operation of the memory cell will be described below. A memory cell of the DRAM is generally constituted by a selection transistor 41 and a capacitor 42, a small charge corresponding to storage data is accumulated and held in a storage node 43 of the capacitor 42. However, leakage necessarily occurs in the capacitor 42. As this leakage, junction leakage which allows charges to flow into a substrate or capacitor insulating film leakage which allows charges to flow into a capacitor electrode 44 is known. Therefore, in order to hold data holding properties, in other words, in order to avoid the leakage, the refresh operation described above must be periodically performed.

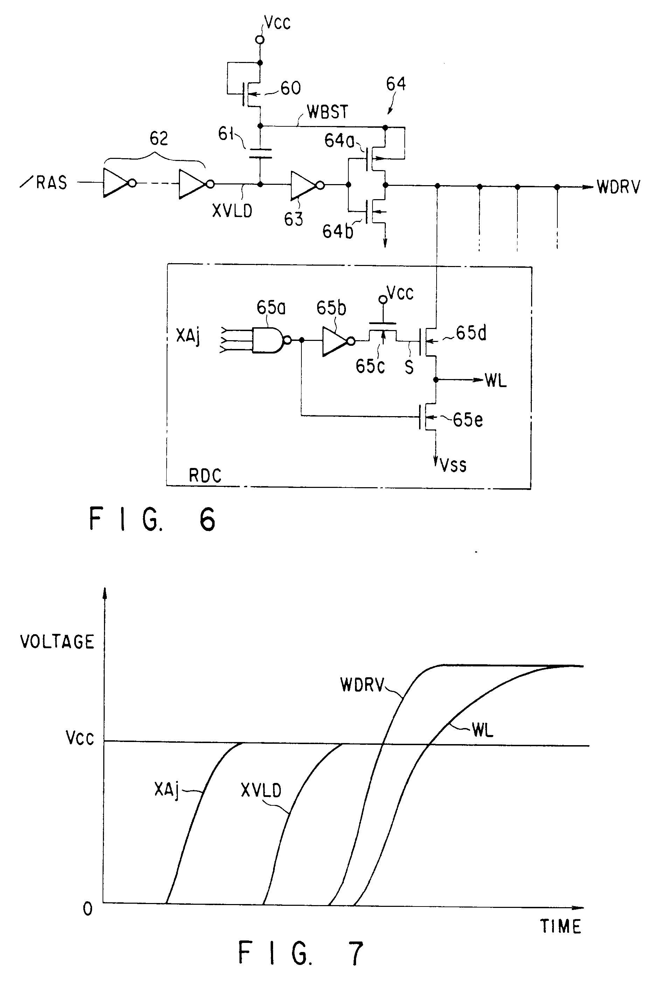

This refresh operation is performed for all the memory cells in 512 refresh cycles/8 msec for, e.g., a 1 Mbit, and in 1024 refresh cycles/16 msec for, e.g., 16 Mbit depending on an external specification. In the example as described above, since the memory cells have a 16-Mbit capacity, when a refresh operation is performed in 2048 refresh cycles/32 msec, as shown in FIG. 5, at least four word lines 51 to 54 (more accurately, the RDC 24a) are commonly used for the memory cell arrays 22a and 22b, and an RDC 24b is commonly used for memory cell arrays 22c and 22d. For this reason, 8 word lines are selected. In contrast to this, when one word line, e.g., the word line 51, is selected, the three word lines 52 to 54 related to the word line 51 are selected simultaneously with the word line 51. In addition, as shown in FIG. 5, other word lines are not selected at random, and the word lines are selected in units of minimum memory arrays. The memory cell array selected as described above is called an activated memory cell array.

FIG. 6 shows a word line drive circuit including a row decoder (RDC), and FIG. 7 shows the timings of main nodes of the word line drive circuit.

Referring to FIG. 6, a power supply voltage Vcc is applied to the drain and gate of an n-channel MOS transistor (to be referred to as an NMOS hereinafter) 60, and the source of the NMOS 60 is connected to one terminal of a capacitor 61 having a large capacitance. This NMOS 60 is normally set in an ON state, and a potential WBST of the source is set to be the power supply voltage Vcc. A row address strobe signal (/RAS) is supplied to a delay circuit 62 obtained by connecting a plurality of inverter circuits in series, and the row address strobe signal is delayed by the delay circuit 62 by a predetermined period of time so as to be output from the delay circuit 62 as a signal XVLD. This signal XVLD is supplied to the other terminal of the capacitor 61, and supplied to the gates of a p-channel MOS transistor (to be referred to as a PMOS hereinafter) 64a and an NMOS 64b through an inverter circuit 63. The PMOS 64a and NMOS 64b constitute an inverter circuit 64.

When the signal XVLD changes from low level to high level, the potential WBST is boosted to a potential higher than the power supply voltage Vcc through the capacitor 61, and the PMOS 64a is turned on. For this reason, the boosted potential WBST is applied to each row decoder (RDC) as a word line drive voltage (WDRV). In each row decoder, a word line is selected in accordance with a combination of address signals. The number of word lines selected as described above is the number of word lines determined by the refresh operation described above.

Each row decoder (RDC) is constituted by a NAND circuit 65a for outputting a logic signal in accordance with an internal signal XAj generated in correspondence with an address signal, an inverter circuit 65b, and NMOSs 65c, 65d, and 65e. The NMOS 65d automatically transfers the boosted voltage to a word line WL using capacitive coupling between the gate and channel of the NMOS. The NMOS 65c encloses the potential of a drain node D.

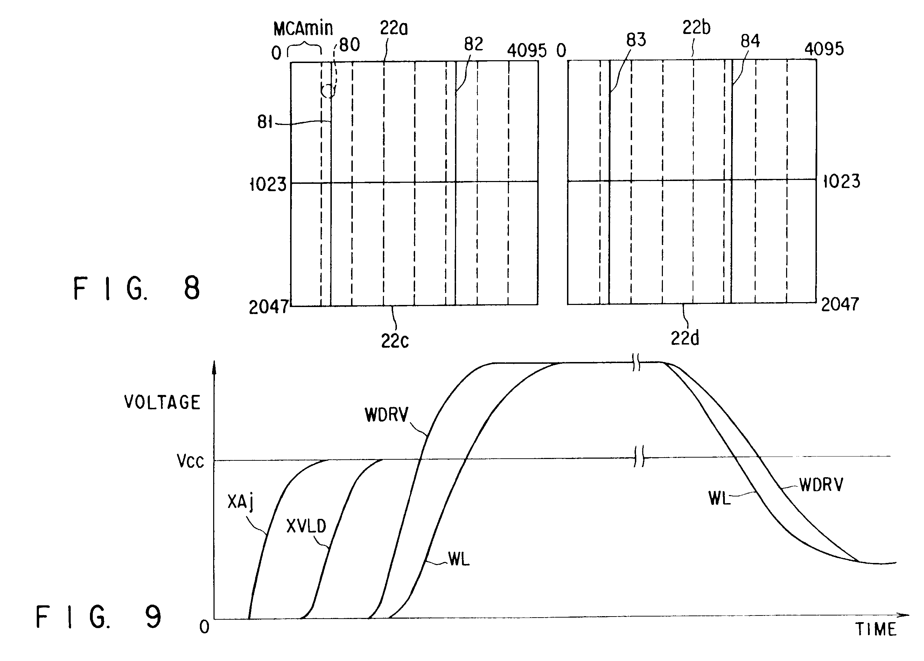

Assume that a failure has occurred due to a certain reason at a portion indicated by reference numeral 80 in the memory cell array 22a shown in FIG. 8, and that a word line is subjected to leakage. This failure can be easily remedied by a redundancy circuit. However, a DRAM is tested in a long cycle, the failure causes a failure bit map indicated by reference numerals 81 to 84. That is, the word lines 82 to 84 selected simultaneously with the word line 81 are regarded as word lines in which failures have occurred.

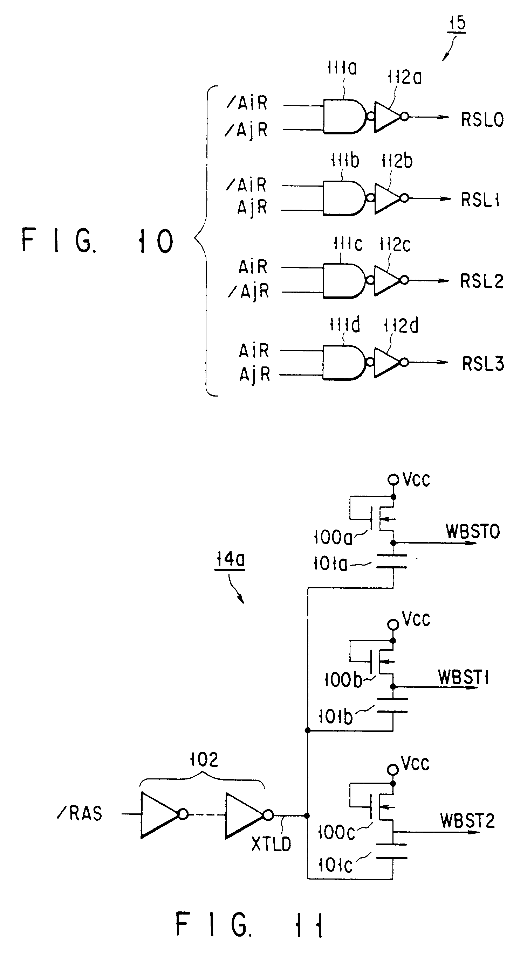

This is because leakage occurs at the portion 80 in which a failure has occurred and which is shown in FIG. 8. When the long-cycle test is performed, as shown in FIG. 9, the potential of the word line drive voltage (WDRV) is dropped. Therefore, the potential is dropped regardless of charging the capacitor 61, and the word lines selected simultaneously with the word line in which a failure has occurred are damaged to fail.

In this case, the following problem is posed. That is, word lines in which no failure has actually occurred and which are not damaged are remedied by a redundancy circuit together with a word line in which a failure has occurred. For this reason, the word lines which are actually damaged are to be remedied by the redundancy circuit, and the number of damaged word lines may become larger than the number of word lines which can be remedied by the redundancy circuit. In this manner, since products which cannot be remedied are regarded as defective products, a yield is merely decreased.

The number of word lines which can be remedied is as follows. For example, in FIG. 8, it is assumed that one word line in which a failure has occurred can be remedied in each minimum memory cell array MCAmin obtained by dividing a memory cell array with dotted lines. In the semiconductor memory described above, if a failure is present in the word line 82 together with another failure, the minimum memory cell array having the word line 82 cannot be remedied. Therefore, this product is regarded as a defective one.

As described above, in the conventional semiconductor memory apparatus, when a word line is subjected to leakage, and a failure has occurred in the word line due to this leakage, a long-cycle test disadvantageously recognizes that failures have occurred in other normal word lines which are selected simultaneously with the word line in which the failure has occurred.

Document EP 0 488 265 A1 whereon the preamble of claim 1 is based, discloses a semiconductor memory device wherein a row decoder and a word line drive circuit are arranged in correspondence to each memory cell array. Hence, this document discloses a structure for selecting different word lines by different word line drive circuits and driving the sense amplifier after a time predetermined by the delay circuit.

It is the object of the present invention to prevent a reduction of the potentials of word lines selected simultaneously with a defective word line.

The object of the present invention can be achieved by a semiconductor memory apparatus comprising:
a plurality of memory cell arrays including a plurality of word lines;
a plurality of first selecting means each respectively provided for a respective one of said memory cell arrays for simultaneously selecting word lines of said memory cell arrays in accordance with an address signal; and
a plurality of word line drive means each respectively connected to a respective one of said first selecting means for boosting a power supply voltage characterized in that each of said word line drive means generates a plurality of drive voltages WDRV0-WDRV3 for driving said word lines and supplies the drive voltages to its respective first selecting means.

According to the present invention, word line drive means are arranged in memory cell arrays or memory cell array blocks or memory cell arrays selected by redundancy circuits, so that the memory cell arrays or memory cell array blocks are respectively driven by the word line drive means. For this reason, the potentials of a plurality of normal word lines selected simultaneously with a word line in which a failure has occurred can be prevented from being dropped. Therefore, the normal word lines selected simultaneously with the word line in which a failure has occurred are prevented from failures, redundancy circuits can be prevented from being unnecessarily used, and a decrease in yield can be prevented.

This invention can be more fully understood from the following detailed description when taken in conjunction with the accompanying drawings, in which:
FIG. 1 is a block diagram showing the arrangement of the first embodiment of the present invention;
FIG. 2 is a plan view showing the layout of a conventional semiconductor memory;
FIG. 3 is a plan view showing a 16-Mbit semiconductor memory map;
FIG. 4 is an equivalent circuit diagram showing a storage element of a DRAM;
FIG. 5 is a plan view showing a memory cell map in a case wherein a word line is selected in accordance with a refresh cycle;
FIG. 6 is a diagram showing the arrangement of a word drive circuit;
FIG. 7 is a timing chart showing an operation of the word line drive circuit shown in FIG. 6;
FIG. 8 is a plan view showing a case wherein a long cycle test of a semiconductor memory in which a failure has occurred is performed;
FIG. 9 is a timing chart showing an operation of a word line drive circuit during the long cycle test;
FIG. 10 is a circuit diagram showing a memory cell array selection circuit shown in FIG. 1;
FIG. 11 is a circuit diagram showing part of a word line drive circuit shown in FIG. 1;
FIG. 12 is a circuit diagram showing part of the word line drive circuit shown in FIG. 1;
FIG. 13 is a circuit diagram showing a row decoder shown in FIG. 1;
FIG. 14 is a view showing the arrangement of the second embodiment of the present invention;
FIG. 15 is a circuit diagram showing a refresh determination circuit shown in FIG. 14;
FIG. 16 is a circuit diagram showing an address control circuit included in a row address buffer circuit shown in FIG. 14;
FIG. 17 is a circuit diagram showing a memory cell array selection circuit shown in FIG. 14;
FIG. 18 is a table showing the relationship between input signals and output signals in FIG. 17;
FIG. 19 is a circuit diagram showing a word line drive circuit shown in FIG. 14;
FIG. 20 is a schematic diagram showing a circuit for generating switching signals shown in FIG. 19;
FIG. 21 is a table showing the relationship between input signals and output signals shown in FIG. 20;
FIG. 22 is a circuit diagram showing a row decoder shown in FIG. 14;
FIG. 23 is a circuit diagram showing the row decoder shown in FIG. 14;
FIG. 24 is a block diagram showing the arrangement of the third embodiment of the present invention;
FIG. 25 is a block diagram showing the arrangement of the fourth embodiment of the present invention;
FIG. 26 is a circuit diagram showing a word line selection control circuit shown in FIG. 25; and
FIG. 27 is a circuit diagram showing a memory cell array selection circuit shown in FIG. 25.

Embodiments of the present invention will be described below with reference to the accompanying drawings.

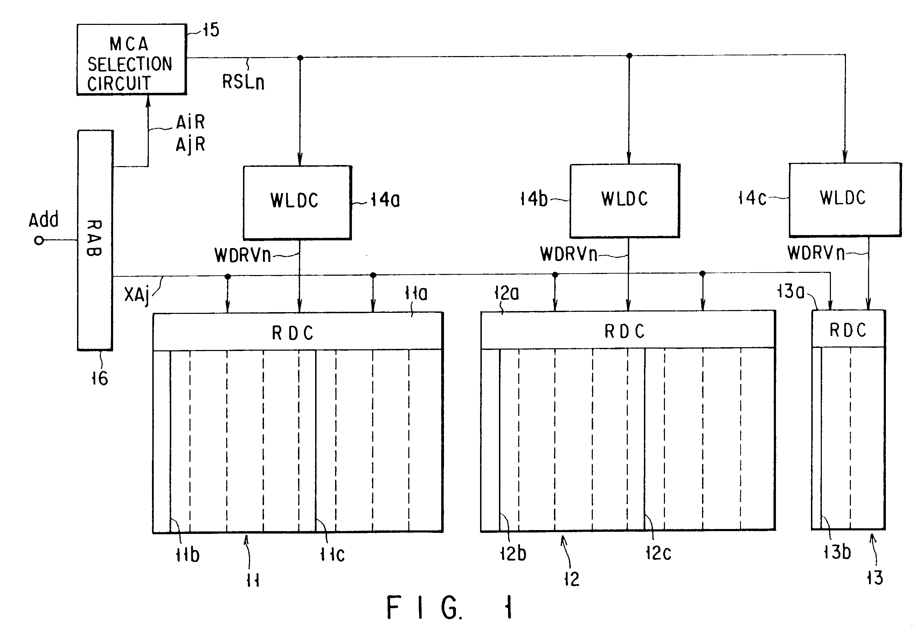

FIG. 1 shows the first embodiment of the present invention, in which word line drive circuits are arranged in units of memory cell arrays.

Referring to FIG. 1, a memory cell array 11 corresponds to one of the memory cell arrays 22a and 22b in the semiconductor memory shown in FIG. 2, and a memory cell array 12 corresponds to one of the memory cell arrays 22c and 22d in the semiconductor memory in FIG. 2. Reference numeral 13 denotes a parity memory cell array. Row decoders 11a, 12a, and 13a are provided to the memory cell arrays 11, 12, and 13, respectively. Word line drive circuits (WLDC) 14a, 14b, and 14c are connected to the row decoders 11a, 12a, and 13a, respectively. The word line drive circuits 14a, 14b, and 14c are operated in accordance with an output signal from a memory cell array selection circuit 15, and the memory cell arrays 11, 12, and 13 are simultaneously driven by the word line drive circuits 14a, 14b, and 14c, respectively.

An address signal Add is supplied to a row address buffer circuit (RAB) 16. The row address buffer circuit 16 outputs internal signals AiR, AjR, XAj, and the like corresponding to an address signal constituted by lower two bits of the address signal Add. The internal signals AiR and AjR are supplied to the memory cell array (MCA) selection circuit 15, and memory cell array selection signals RSLn are output from the memory cell array selection circuit 15. The memory cell array selection signals RSLn activate minimum memory cell arrays arranged in the memory cell arrays 11 to 13, and the memory cell array selection signals RSLn are supplied to the word line drive circuits 14a, 14b, and 14c, respectively.

FIG. 10 shows the memory cell array selection circuit 15. The memory cell array selection circuit 15 is constituted by NAND circuits 111a to 111d and inverter circuits 112a to 112d. Internal signals /AiR and /AjR output from the row address buffer circuit 16 are supplied to the input terminals of the NAND circuit 111a, and a memory cell array selection signal RSL0 is output from the inverter circuit 112a connected to the NAND circuit 111a. The internal signals /AiR and AjR are supplied to the input terminals of the NAND circuit 111b, and a memory cell array selection signal RSL1 is output from the inverter circuits 112b connected to the NAND circuit 111b. The internal signals AiR and /AjR are supplied to the input terminals of the NAND circuit 111c, and a memory cell array selection signal RSL2 is output from the inverter circuit 112c connected to the NAND circuit 111c. The internal signals AiR and AjR are supplied to the input terminals of the NAND circuit 111d, and a memory cell arrays selection signal RSL3 is output from the inverter circuit 112d connected to the NAND circuit 111d.

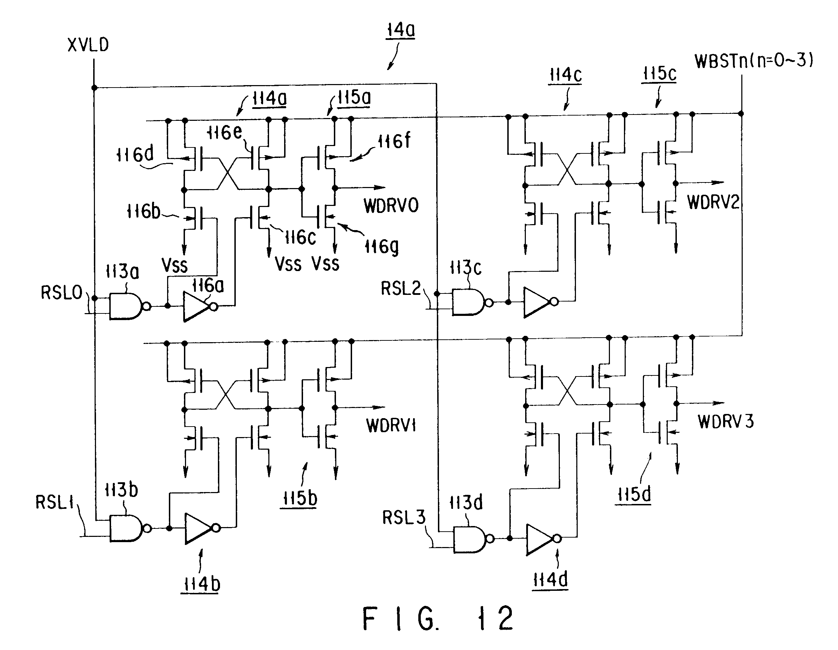

FIGS. 11 and 12 show the word line drive circuits 14a, 14b, and 14c. In this case, since the word line drive circuits 14a, 14b, and 14c have identical arrangements, only the word line drive circuit 14a will be described below. Each word line drive circuit is constituted by a boosted potential generating circuit for generating a boosted potential and a word line drive voltage generating circuit for generating a word line drive voltage.

FIG. 11 shows the boosted potential generating circuit. Referring to FIG. 11, a power supply voltage Vcc is applied to the drain and gate of each of NMOSs 100a to 100c, and each source is connected to one terminal of a corresponding one of the capacitors 101a to 101c each having a large capacitance. The NMOSs 100a to 100c are always set in an ON state, and potentials WBST0 to WBST3 of the sources are set to be the power supply voltage Vcc. A row address strobe signal /RAS is supplied to a delay circuit formed by connecting a plurality of inverters in series, and a signal XVLD obtained by delaying the row address strobe signal /RAS by a predetermined period of time is output from the delay circuit 102. This signal XVLD is supplied to the other terminal of each of the capacitors 101a to 101c. When the signal XVLD changes from low level to high level in accordance with a change in the row address strobe signal /RAS, the potentials WBST0 to WBST3 are boosted to potentials higher than the power supply voltage Vcc through the capacitors 101a to 101c, respectively.

FIG. 12 shows a word line drive voltage generating circuit. Referring to FIG. 12, each of the memory cell array selection signals RSL0 to RSL3 output from the inverter circuits 112a to 112d constituting the memory cell array selection circuit 15 is supplied to one terminal of a corresponding one of NAND circuits 113a to 113d. The signal XVLD is supplied to the other terminal of each of the NAND circuits 113a to 113d. Output signals from the NAND circuits 113a to 113d are supplied to the inverter circuits 115a to 115d through level conversion circuits 114a to 114d. The internal signals AiR and AjR and memory cell array selection signals RSLn (n = 0 to 3) generated by these internal signals are signals at the power supply potential (Vcc level). The level conversion circuits 114a to 114d convert the signals at the power supply potential into signals at boosted potential WBSTn levels, and the signals at the potentials WBSTn are supplied to the inverter circuits 115a to 115d for outputting the potentials WBSTn, respectively. Therefore, the inverter circuits 115a to 115d are prevented from being erroneously operated.

Since the sets of the level conversion circuits 114a to 114d and the inverter circuits 115a to 115d have identical arrangements, only the arrangement of the set of the level conversion circuit 114a and the inverter circuit 115a will be described below. The input terminals of the gates of an inverter circuit 116a and an NMOS 116b are connected to the output terminal of the NAND circuit 113a. The output terminal of the inverter circuit 116a is connected to the gate of an NMOS 116c. The sources of the NMOSs 116b and 116c are set to be a predetermined potential Vss. The drain of the NMOS 116b is connected to the drain of a PMOS 116d and the gate of a PMOS 116e, and the drain of the NMOS 116c is connected to the drain of the PMOS 116e and the gate of the PMOS 116d. The boosted potential, e.g., WBST0, is applied to the sources and back gates (substrate) of the PMOSs 116d and 116e.

The gates of a PMOS 116f and an NMOS 116g constituting the inverter circuit 115a are connected to the connection point between the PMOS 116e and the NMOS 116c. The source of the NMOS 116g is set to be the potential Vss, and the drain of the NMOS 116g is connected to the drain of the PMOS 116f. The potential WBST0 is supplied to the source and back gate of the NMOS 116f.

One of the sets of the level conversion circuits 114a to 114d and the inverter circuits 115a to 115d is selected by the memory cell array selection signals RSL0 to RSL3, and a corresponding one of word line drive voltages WDRV0 to WDRV3 is output from the selected one of the inverter circuits 115a to 115d.

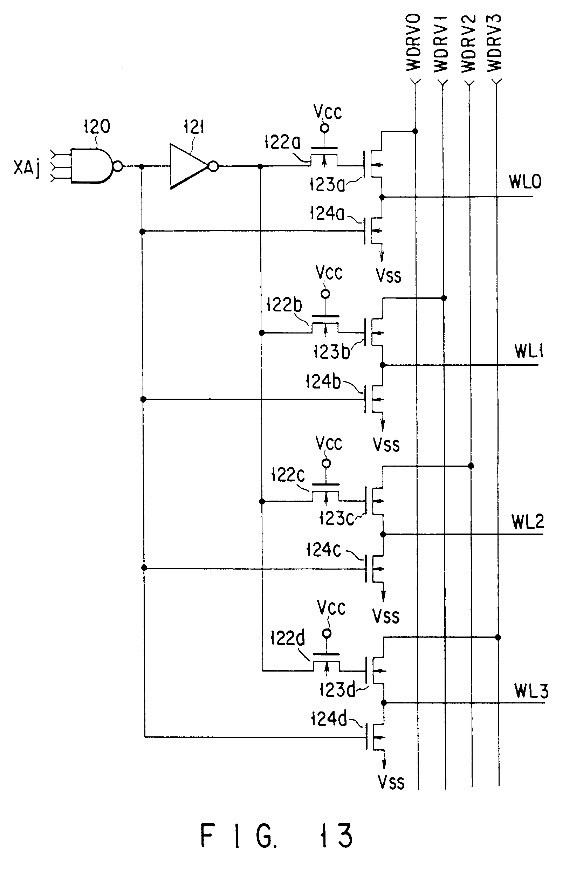

FIG. 13 shows an example of the row decoders 11a, 12a, and 13a. The internal signal XAj output from the row address buffer circuit 16 is supplied to the input terminal of a NAND circuit 120. The output terminal of the NAND circuit 120 is connected to the drains of NMOSs 122a to 122d through an inverter circuit 121. The power supply potential Vcc is applied to the gate of each of the NMOSs 122a to 122d. The sources of the NMOSs 122a to 122d are connected to the gates of NMOSs 123a to 123d, respectively. The word line drive voltages WDRV0 to WDRV3 are applied to the drains of the NMOSs 123a to 123d, respectively, and the sources of the NMOSs 123a to 123d are connected to the drains of NMOSs 124a to 124d, respectively. Each source of the NMOSs 124a to 124d is connected to the potential Vss, and the gates of the NMOSs 124a to 124d are connected to the output terminal of the NAND circuit 120. The sources of the NMOSs 123a to 123d are connected to word lines WL0 to WL3, respectively.

With the above arrangement, the NMOSs 122a to 122d are always set in an ON state. When the output signal from the inverter circuit 121 goes to high level in accordance with the internal signal XAj, the word line drive voltages WDRV0 to WDRV3 are applied to the word lines WL0 to WL3 through the NMOSs 123a to 123d, respectively.

According to the first embodiment, the word line drive circuits 14a, 14b, and 14c are simultaneously operated in accordance with the memory cell array signals RSLn output from the memory cell array selection circuit 15, and the memory cell arrays 11, 12, and 13 are simultaneously driven by the word line drive circuits 14a, 14b, and 14c, respectively. Therefore, in each of the memory cell arrays 11, 12, and 13, as shown in FIG. 1, even when a plurality of word lines 11b, 11c, 12b, 12c, and 13b are simultaneously selected, a normal word line is not erroneously regarded as a word line in which a failure has occurred.

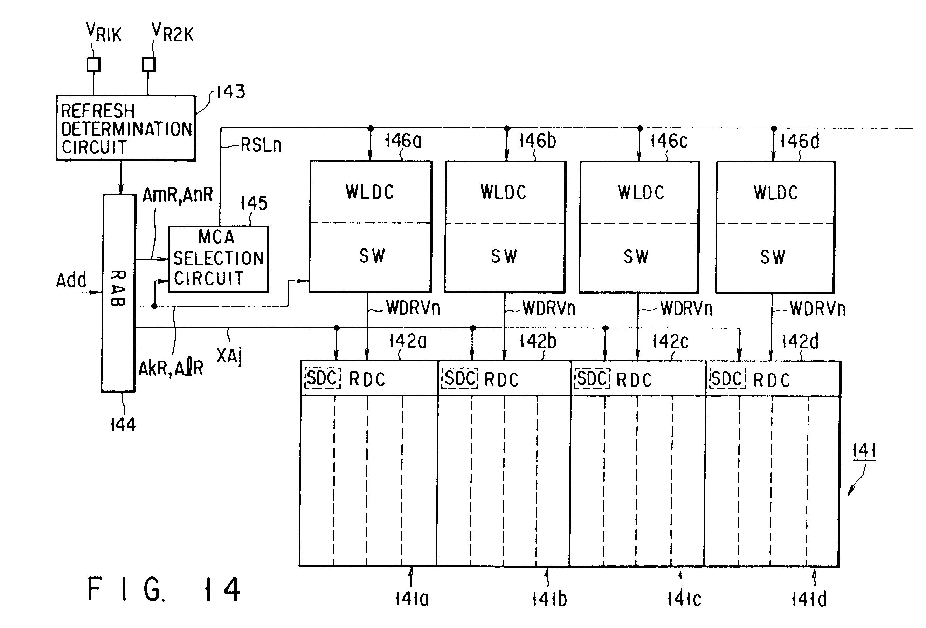

FIG. 14 shows the second embodiment of the present invention. According to this embodiment, word line drive circuits are controlled in units of refreshing word lines. Referring to FIG. 14, a memory cell array 141 corresponds to the memory cell array 22b shown in FIG. 2. The memory cell array 141 is mainly divided into four memory cell array blocks 141a to 141d as indicated by solid lines in FIG. 14. The number of divided blocks corresponds to the number of word lines simultaneously selected in the refresh operation as described above. Each of the memory cell array blocks 141a to 141d is further divided into four minimum memory cell arrays as indicated by dotted lines in FIG. 14. Row decoders (RDC) 142a to 142d are arranged on the memory cell array blocks 141a to 141d, respectively.

On the other hand, control signals V_{R1K} and V_{R2k} for determining a refresh cycle are supplied to a refresh determination circuit 143. This refresh determination circuit 143 outputs signals _{V1k} and _{V2k} representing the refresh cycle in accordance with the control signals V_{R1k} and V_{R2k}. An address signal Add is supplied to a row address buffer circuit (RAB) 144, and the signals V₁ₖ and V₂ₖ are supplied from the refresh determination circuit 143 to the row address buffer circuit 144. Internal signals AkR, AℓR, AmR, AnR, XAj, and the like are output from the row address buffer circuit 144.

The internal signals AkR and AℓR set the number of word lines simultaneously selected in accordance with the refresh cycle. The internal signals AkR, AℓR, AmR, and AnR are supplied to a memory cell array selection circuit 145, and memory cell array selection signals RSLn are output from the memory cell array selection circuit 145 in accordance with the internal signals AkR, AℓR, AmR, AnR. The memory cell array selection signals RSLn activate the minimum memory cell arrays. For example, when n is set to be 0 to 3, the leftmost minimum memory cell array of each memory cell array block is activated in accordance with the signal RSL0, and the minimum memory cell arrays of each memory cell array block are sequentially activated in the right direction. The memory cell array selection signals RSLn are supplied to word line drive circuits 146a to 146d. Each of the word line drive circuits 146a to 146d includes a switch circuit (SW). Each of the switch circuits (SW) switches the number of simultaneously selected word lines in accordance with the internal signals AkR and AℓR output from the row address buffer circuit 144. The word line drive circuits (WLDC) 146a to 146d are connected to the row decoders 142a to 142d, respectively. Word line drive voltage WDRVn (n = 1 to 3) output from the word line drive circuits 146a to 146d are applied to the row decoders 142a to 142d, respectively.

In addition, the internal signal XAj output from the row address buffer circuit 144 is supplied to each of the row decoders 142a to 142d. The internal signal XAj is a signal for selecting a word line in each minimum memory cell array. A spare decoder SDC constituting a redundancy circuit is arranged in each of the row decoders 142a to 142d, and a spare row is selected in place of a word line in which a failure has occurred by the spare decoder SDC.

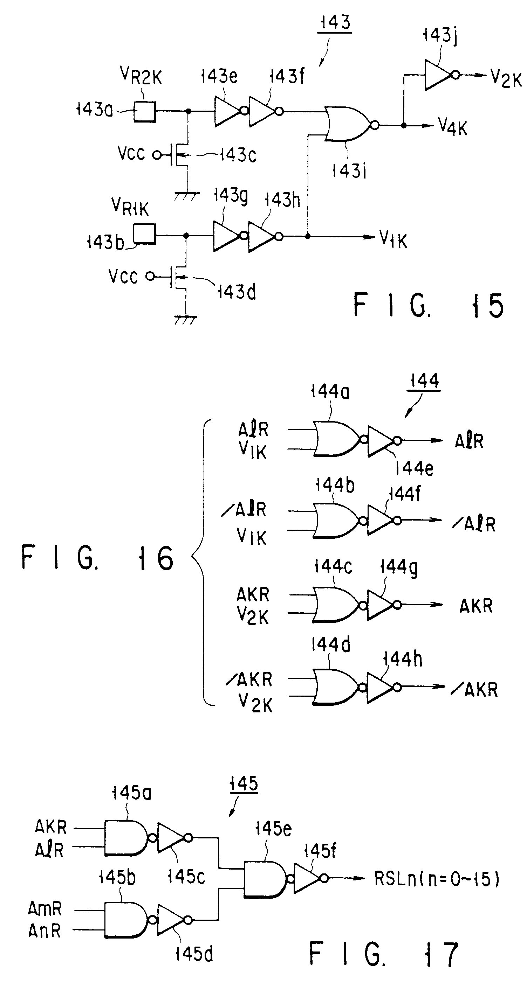

FIG. 15 shows the refresh determination circuit 143 in detail. The control signals V_{R1k} and V_{R2k} are supplied to terminals 143a and 143b, respectively. The terminals 143a to 143b are grounded through NMOSs 143c and 143d functioning as resistors. The terminal 143a is connected to one input terminal of a NOR circuit 143i through inverter circuits 143e and 143f, and the terminal 143b is connected to the other terminal of the NOR circuit 143i through inverter circuits 143g and 143h. A signal V₁ₖ corresponding to 1-k cycle/refresh is output from the output terminal of the inverter circuit 143h, and a signal V₄ₖ corresponding to 4-k cycle/refresh is output from the output terminal of the NOR circuit 143i. An inverter circuit 143j is connected to the output terminal of the NOR circuit 143i, and the signal V₂ₖ corresponding to 2-k cycle/refresh is output from the output terminal of the inverter circuit 143j.

FIG. 16 shows an address control circuit included in the row address buffer circuit 144. The upper two bits of an address signal are controlled in accordance with the signals V₁ₖ and V₂ₖ output from the refresh determination circuit 143. That is, this address control circuit is constituted by NOR circuits 144a to 144d and inverter circuits 144e to 144h respectively connected to the NOR circuits 144a to 144d. An internal signal AℓR and the signal V₁ₖ are supplied to the input terminal of the NOR circuit 144a, and the internal signal AℓR is output from the inverter circuit 144e. An internal signal /AℓR and the signal V₁ₖ are supplied to the input terminal of the NOR circuit 144b, and the internal signal /AℓR is output from the inverter circuit 144f. The internal signal AkR and the signal V₂ₖ are supplied to the input terminal of the NOR circuit 144c, and the internal signal AkR is output from the inverter circuit 144g. An internal signal /AkR and the signal V₂ₖ are supplied to the input terminal of the NOR circuit 144d, and the internal signal /AkR is output from the inverter circuit 144h.

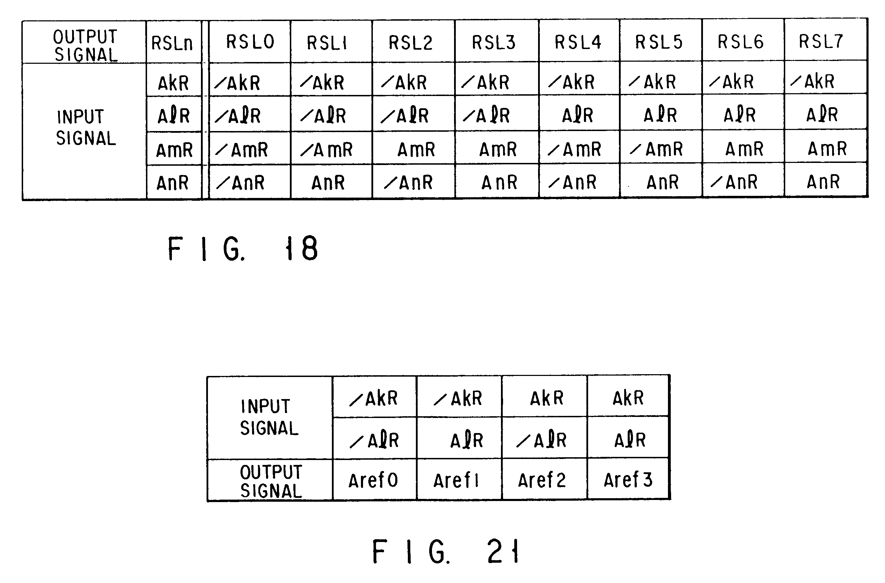

FIG. 17 is a schematic view showing the memory cell array selection circuit 145, and FIG. 18 is a table showing the relationship between input signals and output signals in FIG. 17.

The memory cell array selection circuit 145 includes 16 circuits, one of which is shown in FIG. 17. The internal signals AkR and AℓR are supplied to the input terminal of a NAND circuit 145a, and internal signals AmR and AnR are supplied to the input terminal of a NAND circuit 145b. The output terminal of the NAND circuit 145a is connected to one input terminal of a NAND circuit 145e through an inverter circuit 145c, and the output terminal of the NAND circuit 145b is connected to the other input terminal of the NAND circuit 145e through an inverter circuit 145d. The output terminal of the NAND circuit 145e is connected to the input terminal of an inverter circuit 145f. Memory cell array selection signals RSLn (n = 0 to 15) are output from the output terminal of the inverter circuit 145f.

FIG. 18 shows only the memory cell array selection signals RSL0 to RSL7. Although these memory cell arrays selection signals RSL0 to RSL7 correspond to the internal signal /AkR obtained by inverting the internal signal AkR, the memory cell array selection signals RSL8 to RSL15 (not shown) correspond to the internal signal AkR. The logic of the internal signals AℓR, AmR, and AnR is the same as that of the memory cell array selection signal RSL0 to RSL7.

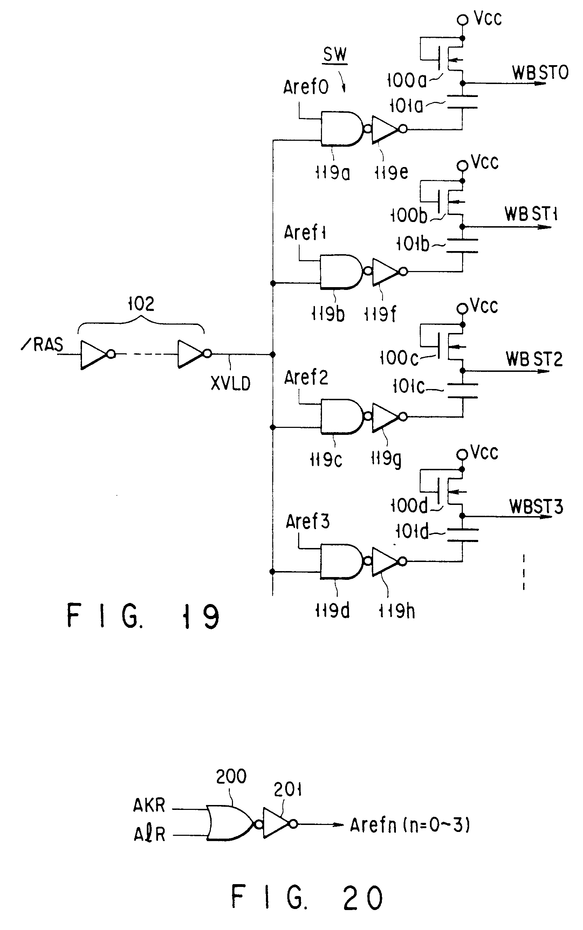

FIG. 19 shows part of the word line drive circuits (WLDC) 146a to 146d including the switch circuits SW. The circuit shown in FIG. 19 is obtained by inserting the switch circuits SW in the boosted potential generating circuit shown in FIG. 11. The same reference numerals as in FIG. 11 denote the same parts in FIG. 19. Note that the number of boosted potentials generated by the word line drive circuit shown in FIG. 19 is larger than the number of boosted potentials generated by the circuit shown in FIG. 11.

Referring to FIG. 19, the output terminal of a delay circuit 102 to which a row address strobe signal /RAS is supplied is connected to one input terminal of each of NAND circuits 119a to 119d constituting the switch circuits SW. Switching signals Aref0 to Aref3 are input to the other input terminals of the NAND circuits 119a to 119d. The output terminals of the NAND circuits 119a to 119d are connected to capacitors 101a to 101d through inverter circuits 119e to 119h, respectively.

In the above arrangement, when an XVLD goes to high level in accordance with the row address strobe signal /RAS, input conditions are satisfied in only NAND circuits whose switching signals (Aref0 to Aref3) are set at high level. For example, when the switching signal Aref0 is set at high level, the power supply potential Vcc is applied to the capacitor 101a through the inverter circuit 119e to boost the WBST0 to the power supply potential Vcc or more. The boosted potentials WBST0 to WBST3 are applied to the same circuit as the word line drive voltage generating circuit shown in FIG. 12. This circuit generates the word line drive voltages WDRV0 to WDRV3.

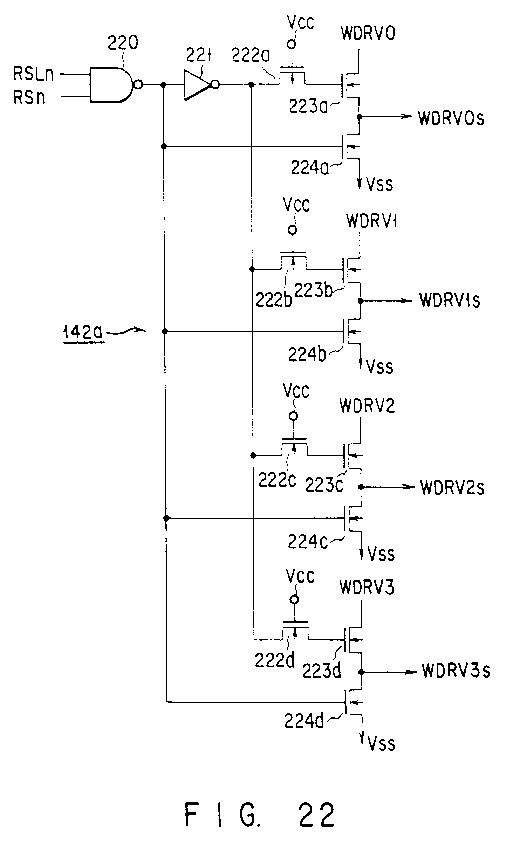

FIG. 20 is a schematic view showing a circuit for generating the switching signals Aref0 to Aref3, and FIG. 21 shows the relationship between input signals and output signals in FIG. 20.

In FIG. 20, the switching signals Aref1 to Aref3 are generated by a NOR circuit 200 and an inverter circuit 201. That is, four circuits, one of which is shown in FIG. 20, are actually arranged. The internal signals AkR and AℓR output from the row address buffer circuits 144 are supplied to the input terminals of the NOR circuit 200. The switching signals Aref1 to Aref3 shown in FIG. 21 are output from the inverter circuit 201 in accordance with the combinations of the internal signals AkR and AℓR.

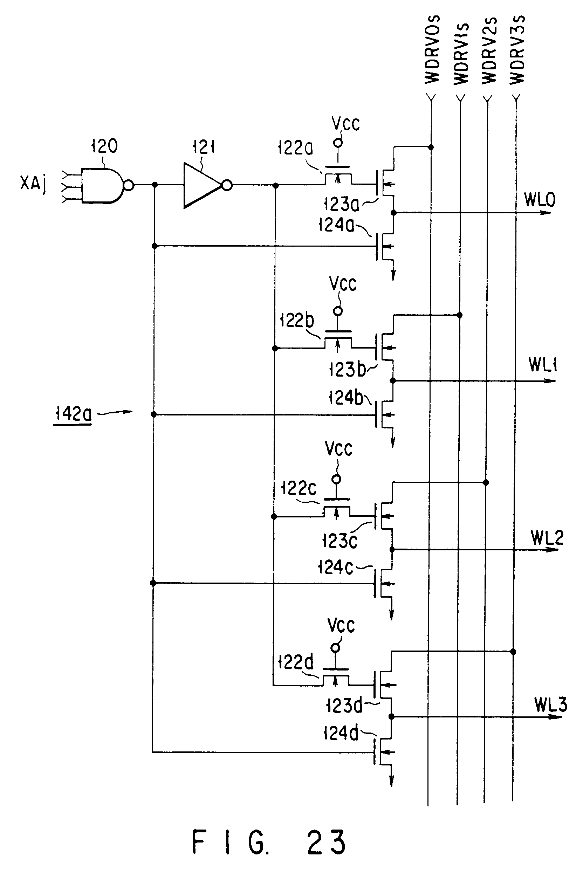

FIGS. 22 and 23 show the row decoders 142a to 142d. The row decoders 142a to 142d have identical arrangements. Each of the row decoders 142a to 142d is constituted by a first decoder for determining a memory cell array block shown in FIG. 22 and a second decoder for determining a word line shown in FIG. 23.

In the first decoder shown in FIG. 22, the memory cell array selection signals RSLn output from the memory cell array selection circuit 145 are supplied to one input terminal of a NAND circuit 220, a selection inhibition signal RSn is supplied to the other input terminal. This selection inhibition signal RSn is supplied from the spare decoder SDC when a failure has occurred in a word line.

The output terminal of the NAND circuit 220 is connected to the drain of each of NMOSs 222a to 222d through an inverter circuit 221. The power supply potential Vcc is supplied to the gate of each of the NMOSs 222a to 222d, and the sources of the NMOSs 222a to 222d are connected to the gates of the NMOSs 223a to 223d, respectively. The word line drive voltages WDRV0 to WDRV3 are applied to the drains of the NMOSs 223a to 223d, respectively, and the sources of the NMOSs 223a to 223d are connected to the drains of NMOSs 224a to 224d, respectively. The source of each of the NMOSs 224a to 224d is connected to the potential Vss, and the gates of the NMOSs 224a to 224d are connected to the output terminal of the NAND circuit 220. The word line drive voltages WDRV0 to WDRV3 are output from the sources of the NMOSs 223a to 223d as voltages WDRV0s to WDRV3s.

In the first decoder, when a refresh operation is performed in 1-k cycle, the memory cell array blocks 141a to 141d shown in FIG. 14 are simultaneously selected; when a refresh operation is performed in 2-k cycle, the memory cell array blocks 141a and 141b shown in FIG. 14 are simultaneously selected, and the memory cell array blocks 141c and 141d are simultaneously selected.

On the other hand, the second decoder shown in FIG. 23 is the same circuit as that shown in FIG. 13 except for voltages applied to the drains of NMOSs 123a to 123d. That is, although the word line drive voltages WDRV0 to WDRV3 are applied to the drains of the NMOSs 123a to 123d in the circuit shown in FIG. 13, respectively, the voltages WDRV0s to WDRV3s output from the first decoder are applied to the drains of the NMOS 123a to 123d in the second decoder shown in FIG. 23.

In the above arrangement, NMOSs 122a to 122d are always set in an ON state. When an output signal from the inverter circuit 121 goes to high level, the NMOSs 123a to 123d are turned on, and a word line drive voltage is output from only an NMOS to which a corresponding one of the voltages WDRVns (n = 0 to 3) is applied.

According to the second embodiment of the present invention, the memory cell array blocks 141a to 141d are respectively controlled by the word line drive circuits 146a to 146d in accordance with a refresh cycle. For this reason, when a row failure has occurred in a word line included in a memory cell array of the memory cell array block 141a, the potentials of word lines selected simultaneously with the above word line and included in a memory cell array of another memory cell array block can be prevented from being decreased. Therefore, since a normal word line selected simultaneously with a word line in which a failure has occurred is not regarded as a word line in which a failure has occurred, the yield can be increased without unnecessarily using a redundancy circuit.

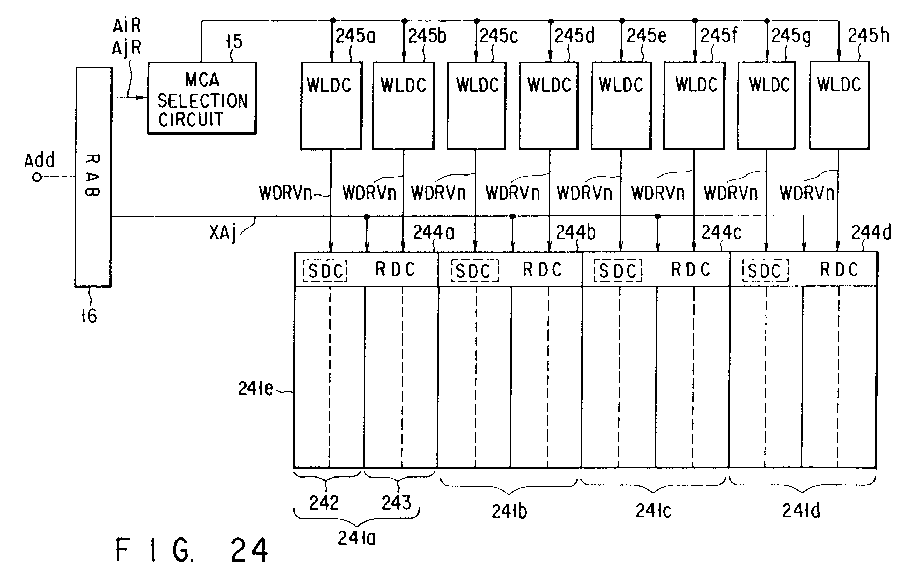

FIG. 24 shows the third embodiment of the present invention.

The operation unit of a redundancy circuit is generally smaller than the unit of a refresh operation. For this reason, in this embodiment, each redundancy circuit has a word line drive circuit. That is, in each of memory cell array blocks 241a to 241d, reference numeral 241e denotes a minimum memory cell array; 242, a spare memory cell array selected by a spare decoder SDC; and 243, a memory cell array serving as the unit of a refresh operation. Row decoders 244a to 244d are connected to the memory cell array blocks 241a to 241d, respectively. Each of the row decoders 244a to 244d has the same arrangement as the above-described arrangement shown in FIG. 13 and further includes a spare decoder SDC. When a word line in which a failure has occurred is selected, a spare row (not shown) is selected by the spare decoder SDC.

A plurality of word line drive circuits (WLDC) 245a to 245h are connected to a memory cell array selection circuit 15. The memory cell array selection circuit 15 has the same arrangement as shown in FIG. 10, and each of the word line drive circuits 245a to 245h has the same arrangements as shown in FIGS. 11 and 12. Although the potentials WBST0 to WBST2 are output in the arrangement shown in FIG. 11, potentials WBST0 to WBST3 are generated in this embodiment.

The word line drive circuits 245a and 245b are connected to the row decoder 244a, and the word line drive circuits 245c and 245d are connected to the row decoder 244b. In addition, the word line drive circuits 245e and 245f are connected to the row decoder 244c, and the word line drive circuits 245g and 245h are connected to the row decoder 244d.

In the above arrangement, the word line drive circuits 245a to 245h are simultaneously operated in accordance with the memory array selection signals RSLn output from the memory cell array selection circuit 15, and word line drive voltages WDRVn are simultaneously output from the word line drive circuits 245a to 245h. Therefore, the spare memory cell array 242 selected by a spare decoder and the memory cell array 243 serving as the unit of a refresh operation are respectively driven by the different word line drive voltages WDRVn. For this reason, even when a plurality of word lines are simultaneously selected, a normal word line is not regarded as a word line in which a failure has occurred.

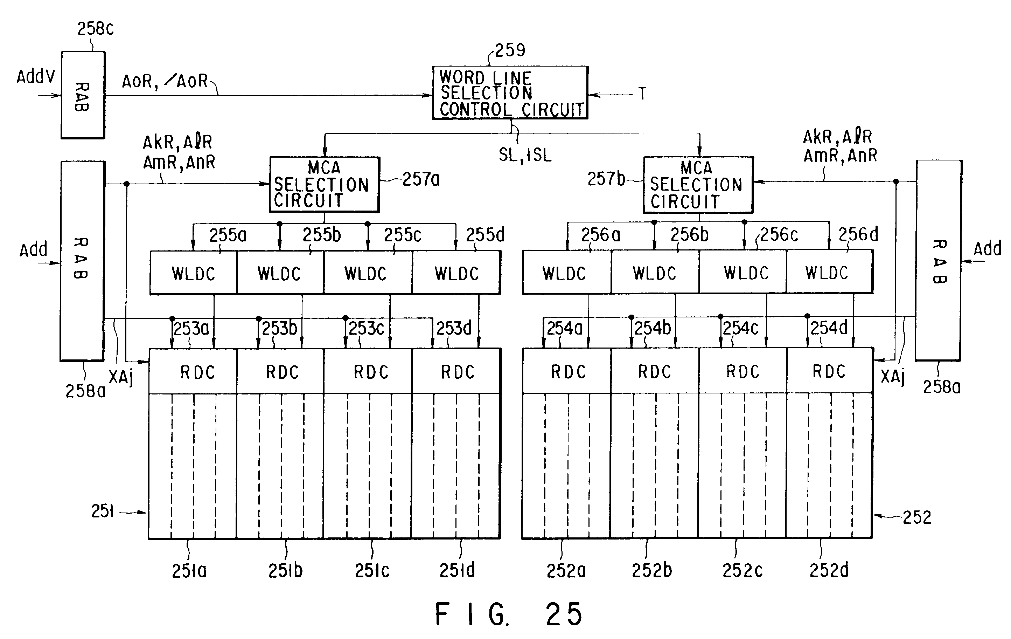

FIG. 25 shows the fourth embodiment of the present invention. This embodiment has a test mode. In this test mode, word lines are selected in units of memory cell arrays. In this case, a plurality of word lines are not simultaneously selected for each refresh cycle.

In this embodiment, memory cell arrays 251 and 252 correspond to the memory cell arrays 22b and 22d shown in FIG. 2. The memory cell array 251 includes memory cell array blocks 251a to 251d, and the memory cell array 252 includes memory cell array blocks 252a to 252d. Row decoders 253a to 253d are provided to the memory cell array blocks 251a to 251d, respectively, and row decoders 254a to 254d are provided to the memory cell array blocks 252a to 252d, respectively. Word line drive circuits (WLDC) 255a to 255d are arranged for the row decoders 253a to 253d, respectively, and word line drive circuits 256a to 256d are arranged for the row decoders 254a to 254d, respectively. These word line drive circuits 255a to 255d and 256a to 256d are operated in accordance with output signals from memory cell array selection circuits 257a and 257b.

Address signals Add are supplied to row address buffer circuits (RAB) 258a and 258b, respectively, and internal signals AkR, AℓR, AmR, AnR, and XAj are output from the row address buffer circuits 258a and 258b. Of these internal signals, the internal signals AkR, AℓR, AmR, and AnR are supplied to each of the memory cell array selection circuits 257a and 257b, and the internal signal XAj is supplied to each of the row decoders 253a to 253d and 254a to 254d.

A virtual address signal Addv for selecting a memory cell array is supplied to a row address buffer circuit 258c. This virtual address signal Addv is, e.g., a 1-bit signal, and it is supplied to the row address buffer circuit 258c in the test mode. The row address buffer circuit 258c outputs an internal signal AoR or /AoR corresponding to the virtual address signal Addv. The signal AoR or /AoR is supplied to a word line selection control circuit 259 together with a test signal T for setting the test mode. This word line selection control circuit 259 is connected to the memory cell array selection circuits 257a and 257b. When the word line selection control circuit 259 receives the test signal T, the word line selection control circuit 259 outputs signals SL and /SL for selecting one of the memory cell arrays 251 and 252 in accordance with the virtual address signal Addv. The signals SL and /SL are supplied to the memory cell array selection circuits 257a and 257b, respectively.

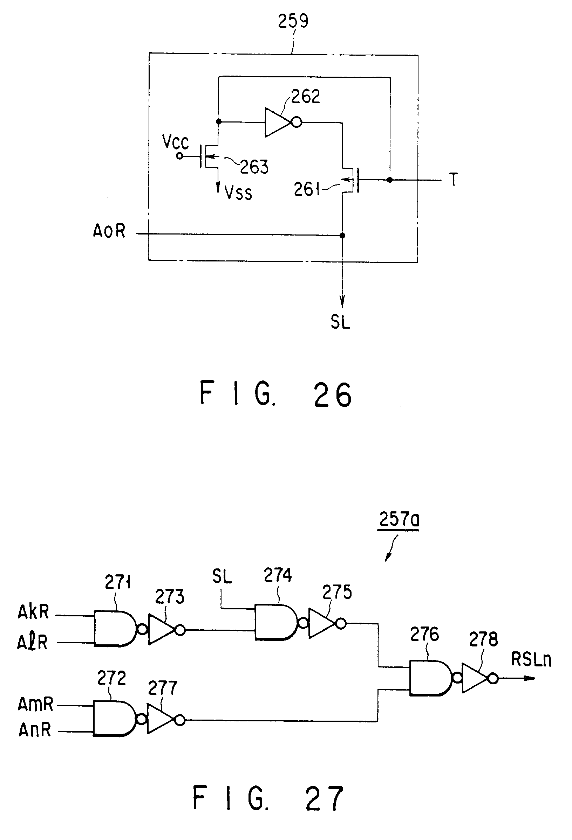

FIG. 26 shows an example of the word line selection control circuit 259. The test signal T is supplied to the gate of a PMOS 261 and the input terminal of an inverter circuit 262. The drain of an NMOS 263 operating as a resistor is connected to the input terminal of the inverter circuit 262. The output terminal of the inverter circuit 262 is connected to the source of the PMOS 261, and the drain of the PMOS 261 is connected to the row address buffer circuit 258c and, e.g., the memory cell array selection circuit 257a.

In the above arrangement, the test signal T is set at low level in a non-test mode. For this reason, the PMOS 261 is set in an ON state, the input and output terminals of the inverter circuit 262 are set at low and high levels, respectively, and the signal SL output from the gate of the PMOS 261 is set at high level.

On the other hand, the test signal T is set at high level in the test mode, and the PMOS 261 is set in an ON state. In this state, when the virtual address signal Addv is supplied to the row address buffer circuit 258c, the internal signal AoR corresponding to the virtual address signal Addv is output from the row address buffer circuit 258c, and this internal signal AoR is supplied to the memory cell array selection circuit 257a as the signal SL.

FIG. 27 shows the memory cell array selection circuit 257a or 257b. Since the memory cell array selection circuits 257a and 257b have identical arrangements, only the memory cell array selection circuit 257a will be described below.

The internal signals AkR and AℓR output from the row address buffer circuit 258a are supplied to the input terminals of a NAND circuit 271, and the internal signals AmR and AnR are supplied to the input terminals of a NAND circuit 272. The output terminal of the NAND circuit 271 is connected to one input terminal of the NAND circuit 274 through an inverter circuit 273. The signal SL output from the word line selection control circuit 259 is supplied to the other input terminal of the NAND circuit 274. The output terminal of the NAND circuit 274 is connected to one input terminal of a NAND circuit 276 through an inverter circuit 275. The output terminal of the NAND circuit 272 is connected to the other input terminal of the NAND circuit 276 through an inverter circuit 277, and the output terminal of the NAND circuit 276 is connected to the input terminal of an inverter circuit 278. Memory cell array selection signals RSLn are output from the output terminal of the inverter circuit 278.

In the above arrangement, the signal SL output from the word line selection control circuit 259 is normally set at high level as described above. Therefore, the memory cell array selection signals RSLn output from the inverter circuit 278 are changed in accordance with the internal signals AkR, AℓR, AmR, and AnR.

On the other hand, in the test mode, when the signal SL goes to low level in accordance with the virtual address signal Addv, all the memory cell array selection signal RSLn go to low level. For this reason, an output signal from the memory cell array selection circuit 257a goes to low level, and no word line drive voltages are output from the word line drive circuits 255a to 255d. At this time, the signal SL of high level is supplied to the memory cell array selection circuits 257a and 257b in accordance with the internal signal AoR, and the memory cell array selection circuit 257b outputs the memory cell array selection signals RSLn in accordance with the internal signals AkR, AℓR, AmR, and AnR. Therefore, word line drive voltages are output from the word line drive circuits 256a to 256d, respectively, and the word lines in only the memory cell array 252 can be driven.

According to the embodiment, in the test mode, only the word line in only a memory cell array selected by the virtual address signal, and the memory cell array blocks of the selected memory cell array are respectively driven by different word line drive circuits. Therefore, even in a long-cycle test, a normal word line is not regarded as a word line in which a failure has occurred.

## Claims

1. A semiconductor memory apparatus comprising:
a plurality of memory cell arrays (11-13; 141) including a plurality of word lines (11b-13b);
a plurality of first selecting means (11a-13a; 134a-142d; 244a-244d; 253a-253d; 254a-254d), each respectively provided for a respective one of said memory cell arrays (11-13; 141), for simultaneously selecting word lines (11b-13b) of said memory cell arrays in accordance with an address signal; and
a plurality of word line drive means (14a-14c; 146a-146d; 245a-245h), each respectively connected to a respective one of said first selecting means (11a-13a; 142a-142d; 244a-244d; 253a-253d; 254a-254d) for boosting a power supply voltage characterized in that each of said word line drive means generates a plurality of drive voltages (WDRV0-WDRV3) for driving said word lines and supplies the drive voltages to its respective first selecting means.

2. A semiconductor memory apparatus according to claim 1, wherein said plurality of word line drive means (14a - 14c; 146a-146d; 245a-245h) are operated in accordance with an output signal (RSLn) from selection control means (15; 145; 257a, 257b, 259).

3. A semiconductor memory apparatus according to claim 1, wherein each of said plurality of memory cell arrays (11 - 13; 141) comprise a plurality of first memory cell array blocks (141a - 141d; 241a-241d; 251a-251d, 252a-252d).

4. A semiconductor memory apparatus according to claim 3, characterized by said plurality of first selecting means (11a-13a; 142a- 142d; 244a-244d; 253a-253d; 254-254d) being respectively arranged for said plurality of first memory cell array blocks (141a - 141d; 241a-241d; 251a-251d, 252a-252d) and said plurality of word line drive means (14a-14; 146a - 146d; 245a-245h) being respectively arranged for said plurality of first selecting means (11a-13a; 142a - 142d; 244a-244d; 253a-253d, 254a-254d).

5. A semiconductor memory apparatus according to claims 3 and 4, further comprising second selecting means (142a - 142d; 244a-244d) for selecting a word line included in each of said first memory cell array blocks (141a - 141d; 241a-241d; 251a-251d, 252a-252d) selected by said first selecting means (11a-13a; 142a-142d; 244a-244d; 253a-253d, 254a-254d) in accordance with an address signal, said second selecting means supplying the drive voltage to the selected word line.

6. A semiconductor memory apparatus according to claims 3-5, further comprising setting means (143) for setting a cycle for refreshing memory cells and said first selecting means (11a-13a; 142a-142d; 244a-244d; 253a-253d, 254a-254d) selecting said plurality of first memory cell array blocks (141a-141b; 241a-241d; 251a-251d, 252a-252d) simultaneously in accordance with the refresh cycle set by said setting means (143).

7. A semiconductor memory apparatus according to claim 5, characterized by
said plurality of first memory cell array blocks (141a-141d; 241a - 241d; 251a-251d, 252a-252d) each comprising a second memory cell array block (243) including a plurality of word lines, and a spare memory cell array block (242) including word lines for remedying a word line in which a failure has occurred and which is included in said second memory cell array block (243);
said first and second selecting means (11a-13a; 142a-142d; 244a-244d; 253a-253d, 254a-254d;) being respectively arranged for said second and spare memory cell array blocks (243, 242), for selecting word lines included in said second and spare memory cell array blocks (243, 242) in accordance with an address signal; and
said plurality of word line drive means (14a-14c; 146a-146d; 245a- 245h) being respectively arranged for said second and spare memory cell array blocks (243, 242) for supplying the drive voltage to said second and spare memory cell array blocks (243, 242) respectively selected by said first and second selecting means (11a-13a; 142a-142d; 244a-244d; 253a-253d, 254a-254d).

8. A semiconductor memory apparatus according to claim 1, 2 and 3, characterized by
said plurality of memory cell arrays (11-13; 141) being divided into first and second memory cell arrays (251, 252) each comprising a plurality of said first memory cell array blocks (141a-141d; 241a-241d; 251a-251d, 252a-252d);
said plurality of first selecting means (11a-13a; 142a-142d; 244a-244d; 253a - 253d, 254a - 254d) being arranged in each of said plurality of first memory cell array blocks (141a-141d; 241a-241d; 251a-251d, 252a-252d) included in said first and second memory cell arrays (251, 252), both selecting a word line of each of said plurality of first memory cell array blocks in accordance with address data;
said plurality of word line drive means (14a-14c); 146a-146d; 245a-245h) being divided into first and second word line drive means (255a - 255d, 256a - 256d), respectively arranged for said plurality of first selecting means (11a-13a; 142a-142d; 244a-244d; 253a-253d, 254a-254d);
said selection control means (15; 145; 257a, 257b, 259) being respectively connected to said first and second word line drive means (255a-255d, 256a-256d), for selecting and activating one of said first and second line drive means in accordance with a selecting signal when the selection signal (AoR) for selecting a respective memory cell array block (141a-141d; 241a-241d; 251a-251d, 252a-252d) and a test signal (T) for setting a test mode are supplied to said selection control means (15; 145; 257a, 257b, 259).

9. An apparatus according to any one of claims 1 and 7 characterized in that
each of said word line drive means comprises:
a plurality of transistors (100a - 100c) each of which has one terminal of a current path and a gate which are applied with a power supply voltage;
a plurality of capacitors (101a - 101c) each of which has one terminal connected to another terminal of the current path of a corresponding one of said transistors, and another terminal supplied with a delayed row address strobe signal for boosting a voltage of one terminal of each of said capacitors;
a level conversion circuit (114a), arranged in each memory cell array block, for converting a selection signal having a power supply voltage level for selecting a minimum memory cell array block constituted by a plurality of word lines into the boosted voltage; and
an output circuit (115a) for outputting the boosted voltage in accordance with an output signal from said level conversion circuit.

10. An apparatus according to any one of claims 1 and 7 characterized in that each of said selecting means has at least one transfer gate (123a), turned on in accordance with the address signal, for applying said drive voltage to a word line through the transfer gate.

11. An apparatus according to claims 3-6, characterized in that
each of said word line drive means comprises:
a plurality of transistors (100a - 100d) each of which has one terminal of a current path and a gate which are applied with a power supply voltage;
a plurality of capacitors (101a - 101d) each having one terminal connected to another terminal of the current path of a corresponding one of said transistors;
a plurality of switching means (SW) each of which has one input terminal supplied with a delayed row address strobe signal, another terminal supplied with a switching signal, and an output terminal connected to the other terminal of each of said capacitors, said switching means preventing a boosting operation of each of said capacitors when said switching means receive the switching signal;
a level conversion circuit (114a), arranged in each of said memory cell array blocks, for converting a selection signal for selecting a minimum memory cell array block constituted by a plurality of word lines into the boosted voltage, the selection signal having a power supply voltage level; and
an output circuit (115a) for outputting the boosted voltage in accordance with an output signal from said level conversion circuit.

12. An apparatus according to claims 3-6, characterized in that said first selecting means has at least one first transfer gate (223a), turned on in accordance with the selection signal for selecting said minimum memory cell array, for outputting the drive voltage, and said second selecting means has at least one second transfer gate (123a), turned on in accordance with the address signal, for outputting the drive voltage applied from said first transfer gate (223a) to a word line.

## Patentansprüche

1. Halbleiterspeichervorrichtung umfassend:
eine Vielzahl von Speicherzellen-Arrays (11-13; 141), welche eine Vielzahl von Wortleitungen (11b-13b) enthalten;
eine Vielzahl von ersten Auswahlmitteln (11a-13a; 134a-142d; 244a-244d; 253a-253d; 254a-254d), wovon jedes jeweils vorgesehen ist für ein jeweiliges Speicherzell-Array (11-13; 141), um gleichzeitig Wortleitungen (11b-13b) der Speicherzellen-Arrays in Übereinstimmung mit einem Adresssignal zu wählen; und
eine Vielzahl von Wortleitungs-Betriebsmitteln (14a-14c; 146a-146d; 245a-245h), wovon jedes jeweils mit einem der jeweiligen ersten Auswahlmittel (11a-13a; 142a-142d; 244a-244d; 253a-253d; 254a-254d) verbunden ist, um eine Versorgungsspannung anzuheben, **dadurch gekennzeichnet, dass** jedes der Wortleitungs-Betriebsmittel eine Vielzahl von Betriebsspannungen (WDRV0 - WDRV3) zum Betreiben der Wortleitungen erzeugt, und die Betriebsspannungen an sein jeweiliges erstes Auswahlmittel liefert.

2. Halbleiterspeichervorrichtung nach Anspruch 1, wobei die Vielzahl von Wortleitungs-Betriebsmitteln (14a-14c; 146a-146d; 245a-245h) in Übereinstimmung mit einem Ausgangssignal (RSLn) aus Auswahlsteuermitteln (15; 145; 257a, 257b, 259) arbeiten.

3. Halbleiterspeichervorrichtung nach Anspruch 1, wobei jedes der Vielzahl von Speicherzellen-Arrays (11-13; 141) eine Vielzahl von ersten Speicherzell-Arrayblöcken (141a-141d; 241a-241d; 251a-251d, 252a-252d) umfasst.

4. Halbleiterspeichervorrichtung nach Anspruch 3, **dadurch gekennzeichnet, dass** die Vielzahl von ersten Auswahlmitteln (11a-13a; 142a-142d; 244a-244d; 253a-253d; 254-254d) jeweils für die Vielzahl von ersten Speicherzell-Arrayblöcken (141a-141d; 241a-241d; 251a-251d, 252a-252d) angeordnet ist, und die Vielzahl von Wortleitungs-Betriebsmitteln (14a-14; 146a-146d; 245-245h) jeweils für die Vielzahl von ersten Auswahlmitteln (11a-13a; 142a-142d; 244a-244d; 253a-253d, 254a-254d) angeordnet ist.

5. Halbleiterspeichervorrichtung nach einem der Ansprüche 3 und 4, ferner umfassend zweite Auswahlmittel (142a-142d; 244a-244d) zum Auswählen einer Wortleitung, die in jedem der ersten Speicherzell-Arrayblöcke (141a-141d; 241a-241d; 251a-251d, 252a-252d) enthalten ist, die von den ersten Auswahlmitteln (11a-13a; 142a-142d; 244a-244d; 253a-253d, 254a-254d) in Übereinstimmung mit einem Adresssignal ausgewählt wurden, wobei die zweiten Auswahlmittel die Betriebsspannung an die gewählte Wortleitung liefern.

6. Halbleiterspeichervorrichtung nach einem der Ansprüche 3 - 5, ferner umfassend Einstellmittel (143) zur Einstellung eines Zyklus zum Auffrischen der Speicherzellen, und wobei die ersten Auswahlmittel (11a-13a; 142a-142d; 244a-244d; 253-253d, 254a-254d) die Vielzahl von ersten Speicherzell-Arrayblöcken (141a-141b; 241a-241d; 251a-251d, 252a-252d) gleichzeitig in Übereinstimmung mit dem von den Einstellmitteln (143) eingestellten Auffrischungszyklus auswählen.

7. Halbleiterspeichervorrichtung nach Anspruch 5, **dadurch gekennzeichnet, dass**
die Vielzahl von ersten Speicherzell-Arrayblöcken (141a-141d; 241a-241d; 251a-251d, 252a-252d) jeweils einen zweiten Speicherzell-Arrayblock (243) umfassen, der eine Vielzahl von Wortleitungen enthält, und einen Ersatzspeicherzellen-Arrayblock (242), der Wortleitungen enthält zur Abhilfe bei einer Wortleitung, bei welcher ein Fehler aufgetreten ist, und welche in dem zweiten Speicherzell-Arrayblock (243) enthalten ist;
die ersten und zweiten Auswahlmittel (11a-13a; 142a-142d; 244a-244d; 253a-253d, 254a-254d) jeweils für die zweiten Speicherzell-Arrayblöcke und Ersatzspeicherzellen-Arrayblöcke (243, 242) angeordnet sind, um Wortleitungen zu wählen, die in den zweiten Speicherzell-Arrayblöcken und Ersatzspeicherzellen-Arrayblöcken (243, 242) enthalten sind, in Übereinstimmung mit einem Adresssignal; und
die Vielzahl von Wortleitungs-Betriebsmitteln (14a-14c; 146a-146d; 245a-245h) jeweils angeordnet sind für die zweiten Speicherzell-Arrayblöcke und Ersatzspeicherzellen-Arrayblöcke (243, 242), um die Betriebsspannung an die zweiten Speicherzell-Arrayblöcke und Ersatzspeicherzellen-Arrayblöcke (242, 424) zu liefern, die jeweils von den ersten und zweiten Auswahlmitteln (11a-13a; 142a-142d; 244a-244d; 253-253d, 254a-254d) gewählt wurden.

8. Halbleiterspeichervorrichtung nach einem der Ansprüche 1, 2 oder 3, **dadurch gekennzeichnet, dass** die Vielzahl von Speicherzellen-Arrays (11-13; 141) aufgeteilt ist in erste und zweite Speicherzell-Arrays (251, 252), wovon jedes eine Vielzahl von ersten Speicherzell-Arrayblöcken (141a-141d; 241a-241d; 251a-251d, 252a-252d) umfasst;
die Vielzahl von ersten Auswahlmitteln (11a-13a; 142a-142d; 244a-244d; 253a-253d, 254a-254d) in jedem der Vielzahl von ersten Speicherzell-Arrayblöcken (141a-141d; 241a-241d; 251a-251d, 252a-252d) angeordnet sind, die in den ersten und zweiten Speicherzell-Arrays (251, 252) enthalten sind, wobei beide eine Wortleitung der Vielzahl von ersten Speicherzell-Arrayblöcken in Übereinstimmung mit Adressdaten wählen;
die Vielzahl von Wortleitungs-Betriebsmitteln (14a-14c; 146a-146d; 245a-245h) aufgeteilt ist in erste und zweite Wortleitungs-Betriebsmittel (255a-255d, 256a-256d), die jeweils angeordnet sind für die Vielzahl von ersten Auswahlmitteln (11a-13a; 142a-142d; 244a-244d; 253a-253d, 254a-254d);
die Auswahlsteuermittel (15; 145; 257a, 275b, 259) jeweils verbunden sind mit den ersten und zweiten Wortleitungs-Betriebsmitteln (255a-255d, 256a-256d) zum Wählen und Aktivieren von einem der ersten und zweiten Leitungs-Betriebsmittel in Übereinstimmung mit einem Auswahlsignal, wenn das Auswahlsignal (AoR) zur Auswahl eines jeweiligen Speicherzellen-Arrayblocks (141a-141d; 241a-241d; 251a-251d, 252a-252d) und ein Testsignal (T) zur Einstellung eines Testmodus an die Auswahlsteuermittel (15; 145; 257a-257b, 259) geliefert werden.

9. Vorrichtung nach einem der Ansprüche 1 - 7, **dadurch gekennzeichnet, dass**
jedes der Wortleitungs-Betriebsmittel umfasst:
eine Vielzahl von Transistoren (100a-100c), wovon jeder einen Anschluss eines Strompfades hat, und ein Gate, an das eine Versorgungsspannung angelegt wird;
eine Vielzahl von Kondensatoren (101a-101c), wovon jeder einen Anschluss hat, der mit einem anderen Anschluss des Strompfades eines entsprechenden Transistors verbunden ist, und einen weiteren Anschluss hat, dem ein verzögertes Zeilenadress-Taktpulssignal zugeführt wird, um eine Spannung eines Anschlusses jedes Kondensators anzuheben;
eine Pegelveränderungsschaltung (114a), die in jedem Speicherzell-Arrayblock angeordnet ist, um ein Auswahlsignal umzuwandeln, das einen Versorgungsspannungspegel hat zur Auswahl eines minimalen Speicherzellen-Arrayblocks, der durch eine Vielzahl von Wortleitungen gebildet wird, in die angehobene Spannung; und
eine Ausgangsschaltung (115a) zur Ausgabe der angehobenen Spannung in Übereinstimmung mit einem Ausgangssignal aus der Pegelumwandlungsschaltung.

10. Vorrichtung nach einem der Ansprüche 1 - 7, **dadurch gekennzeichnet, dass** jedes der Auswahlmittel zumindest ein Übertragungstor (123a) hat, das in Übereinstimmung mit dem Adresssignal eingeschaltet wird, zum Anlegen der Betriebsspannung an eine Wortleitung über das Übertragungstor.

11. Vorrichtung nach einem der Ansprüche 3 - 6, **dadurch gekennzeichnet, dass**
jedes der Wortleitungs-Betriebsmittel umfasst:
eine Vielzahl von Transistoren (100a-100d), wovon jeder einen Anschluss eines Strompfades und ein Gate hat, an welche eine Versorgungsspannung angelegt wird; eine Vielzahl von Kondensatoren (101a-101d), wovon jeder einen Anschluss hat, der mit einem anderen Anschluss des Strompfades eines entsprechenden Transistors verbunden ist;
eine Vielzahl von Schaltmitteln (SW), wovon jedes einen Eingangsanschluss hat, dem ein verzögertes Zeilenadress-Taktpulssignal zugeführt wird, einen weiteren Anschluss, dem ein Schaltsignal zugeführt wird und einen Ausgangsanschluss, der mit dem anderen Anschluss jedes Kondensators verbunden ist, wobei die Schaltmittel einen Anhebungsvorgang jedes Kondensators verhindern, wenn die Schaltmittel das Schaltsignal empfangen;
eine Pegelumwandlungsschaltung (114a), die in jedem der Speicherzell-Arrayblöcke angeordnet ist, zur Umwandlung eines Auswahlsignals zum Auswählen eines minimalen Speicherzell-Arrayblocks, der durch eine Vielzahl von Wortleitungen gebildet wird, in die angehobene Spannung, wobei das Auswahlsignal einen Versorgungsspannungspegel hat; und
eine Ausgangsschaltung (115a) zur Ausgabe der angehobenen Spannung in Übereinstimmung mit einem Ausgangssignal aus der Pegelumwandlungsschaltung.

12. Vorrichtung nach einem der Ansprüche 3 - 6, **dadurch gekennzeichnet, dass** das erste Auswahlmittel zumindest ein erstes Übertragungstor (223a) hat, das in Übereinstimmung mit dem Auswahlsignal zum Auswählen des minimalen Speicherzell-Arrays eingeschaltet wird, zur Ausgabe der Betriebsspannung, und das zweite Auswahlmittel zumindest ein zweites Übertragungstor (123a) hat, das in Übereinstimmung mit dem Adresssignal eingeschaltet wird, zur Ausgabe der Betriebsspannung, die aus dem ersten Übertragungstor (223a) angelegt wird, an eine Wortleitung.

## Revendications

1. Appareil de mémoire à semiconducteur comprenant :
une pluralité de réseaux de cellules de mémoire (11-13 ; 141) incluant une pluralité de lignes de mot (11b-13b) ;
une pluralité de premiers moyens de sélection (11a-13a ; 142a-142d ; 244a-244d ; 253a-253d ; 254a-254d) dont chacun est respectivement prévu pour l'un respectif desdits réseaux de cellules de mémoire (11-13 ; 141), pour sélectionner simultanément des lignes de mot (11b-13b) desdits réseaux de cellules de mémoire conformément à un signal d'adresse ; et
une pluralité de moyens de pilotage de ligne de mot (14a-14c : 146a-146d ; 245a-245h) dont chacun est respectivement connecté à l'un respectif desdits premiers moyens de sélection (11a-13a ; 142a-142d ; 244a-244d ; 253a-253d ; 254a-254d) pour amplifier une tension d'alimentation,
caractérisé en ce que chacun desdits moyens de pilotage de ligne de mot génère une pluralité de tensions de pilotage (WDRV0-WDRV3) pour piloter lesdites lignes de mot et applique les tensions de pilotage sur son premier moyen de sélection respectif.

2. Appareil de mémoire à semiconducteur selon la revendication 1, dans lequel les moyens de ladite pluralité de moyens de pilotage de ligne de mot (14a-14c ; 146a-146d ; 245a-245h) sont activés conformément à un signal de sortie (RSLn) en provenance d'un moyen de commande de sélection (15 ; 145 ; 257a, 257b, 259).

3. Appareil de mémoire à semiconducteur selon la revendication 1, dans lequel chacun de ladite pluralité de réseaux de cellules de mémoire (11-13 ; 141) comprend une pluralité de premiers blocs de réseaux de cellules de mémoire (141a-141d ; 241a-241d ; 251a-251d, 252a-252d).

4. Appareil de mémoire à semiconducteur selon la revendication 3, caractérisé en ce que les moyens de ladite pluralité de premiers moyens de sélection (11a-13a ; 142a-142d ; 244a-244d ; 253a-253d ; 254a-254d) sont respectivement agencés pour ladite pluralité de premiers blocs de réseaux de cellules de mémoire (141a-141d ; 241a-241d ; 251a-251d, 252a-252d) et les moyens de ladite pluralité de moyens de pilotage de ligne de mot (14a-14d ; 146a-146d ; 245a-245h) sont respectivement agencés pour ladite pluralité de premiers moyens de sélection (11a-13a ; 142a-142d ; 244a-244d ; 253a-253d, 254a-254d).

5. Appareil de mémoire à semiconducteur selon les revendications 3 et 4, comprenant en outre un second moyen de sélection (142a-142d ; 244a-244d) pour sélectionner une ligne de mot incluse dans chacun desdits premiers blocs de réseaux de cellules de mémoire (141a-141d ; 241a-241d ; 251a-251d, 252a-252d) sélectionnés par ledit premier moyen de sélection (11a-13a ; 142a-142d ; 244a-244d ; 253a-253d ; 254a-254d) conformément à un signal d'adresse, ledit second moyen de sélection appliquant la tension de pilotage sur la ligne de mot sélectionnée.

6. Appareil de mémoire à semiconducteur selon les revendications 3 à 5, comprenant en outre un moyen d'établissement (143) pour établir un cycle pour rafraîchir des cellules de mémoire et ledit premier moyen de sélection (11a-13a ; 142a-142d ; 244a-244d ; 253a-253d ; 254a-254d) sélectionnant ladite pluralité de premiers blocs de réseaux de cellules de mémoire (141a-141d ; 241a-241d ; 251a-251d, 252a-252d) simultanément conformément au cycle de rafraîchissement établi par ledit moyen d'établissement (143).

7. Appareil de mémoire à semiconducteur selon la revendication 5, caractérisé en ce que :
les blocs de ladite pluralité de premiers blocs de réseaux de cellules de mémoire (141a-141d ; 241a-241d ; 251a-251d, 252a-252d) comprennent chacun un second bloc de réseaux de cellules de mémoire (243) incluant une pluralité de lignes de mot et un bloc de réseaux de cellules de mémoire de secours (242) incluant des lignes de mot pour porter remède à une ligne de mot dans laquelle une défaillance s'est produite et qui est incluse dans ledit second bloc de réseaux de cellules de mémoire (243) ;
lesdits premier et second moyens de sélection (11a-13a ; 142a-142d ; 244a-244d ; 253a-253d ; 254a-254d) sont respectivement agencés pour ledit second bloc de réseaux de cellules de mémoire (243) et ledit bloc de réseaux de cellules de mémoire de secours (242) pour sélectionner des lignes de mot incluses dans ledit second bloc de réseaux de cellules de mémoire (243) et dans ledit bloc de réseaux de cellules de mémoire de secours (242) conformément à un signal d'adresse ; et
les moyens de ladite pluralité de moyens de pilotage de ligne de mot (14a-14c ; 146a-146d ; 245a-245h) sont respectivement agencés pour ledit second bloc de réseaux de cellules de mémoire (243) et ledit bloc de réseaux de cellules de mémoire de secours (242) pour appliquer la tension de pilotage sur ledit second bloc de réseaux de cellules de mémoire (243) et ledit bloc de réseaux de cellules de mémoire de secours (242) respectivement sélectionnés par lesdits premier et second moyens de sélection (11a-13a ; 142a-142d ; 244a-244d ; 253a-253d ; 254a-254d).

8. Appareil de mémoire à semiconducteur selon la revendication 1, 2 ou 3, caractérisé en ce que :
ladite pluralité de réseaux de cellules de mémoire (11-13 ; 141) est divisée selon des premier et second réseaux de cellules de mémoire (251, 252) dont chacun comprend une pluralité desdits premiers blocs de réseaux de cellules de mémoire (141a-141d ; 241a-241d ; 251a-251d, 252a-252d) ;
ladite pluralité de premiers moyens de sélection (11a-13a ; 142a-142d ; 244a-244d ; 253a-253d ; 254a-254d) est agencée dans chacun de ladite pluralité de premiers blocs de réseaux de cellules de mémoire (141a-141d ; 241a-241d ; 251a-251d, 252a-252d) inclus dans lesdits premier et second réseaux de cellules de mémoire (251, 252), ces moyens sélectionnant une ligne de mot de chacun de ladite pluralité de premiers blocs de réseaux de cellules de mémoire conformément à des données d'adresse ;
ladite pluralité de moyens de pilotage de ligne de mot (14a-14d ; 146a-146d ; 245a-245h) étant divisée selon des premier et second moyens de pilotage de ligne de mot (255a-255d, 256a-256d) agencés respectivement pour ladite pluralité de premiers moyens de sélection (11a-13a ; 142a-142d ; 244a-244d ; 253a-253d ; 254a-254d) ;
ledit moyen de commande de sélection (15 ; 145 ; 257a, 257b, 259) étant respectivement connecté auxdits premier et second moyens de pilotage de ligne de mot (255a-255d, 256a-256d) pour sélectionner et activer l'un desdits premier et second moyens de pilotage de ligne de mot conformément à un signal de sélection lorsque le signal de sélection (AoR) pour sélectionner un bloc de réseaux de cellules de mémoire respectif (141a-141d ; 241a-241d ; 251a-251d, 252a-252d) et un signal de test (T) pour établir un mode test sont appliqués sur ledit moyen de commande de sélection (15 ; 145 ; 257a, 257b, 259).

9. Appareil selon l'une quelconque des revendications 1 et 7, caractérisé en ce que :
chacun desdits moyens de pilotage de ligne de mot comprend :
une pluralité de transistors (100a-100c) dont chacun comporte une borne d'une voie de courant et une grille se voyant appliquer une tension d'alimentation ;
une pluralité de condensateurs (101a-101c) dont chacun comporte une borne connectée à une autre borne de la voie de courant de l'un correspondant desdits transistors et une autre borne se voyant appliquer un signal de synchronisation d'adresse de rangée retardé pour amplifier une tension d'une borne de chacun desdits condensateurs ;
un circuit de conversion de niveau (114a) agencé dans chaque bloc de réseaux de cellules de mémoire pour convertir un signal de sélection présentant un niveau de tension d'alimentation pour sélectionner un bloc de réseaux de cellules de mémoire minimum constitué par une pluralité de lignes de mot selon la tension amplifiée ; et
un circuit de sortie (115a) pour émettre en sortie la tension amplifiée conformément à un signal de sortie en provenance dudit circuit de conversion de niveau.

10. Appareil selon l'une quelconque des revendications 1 et 7, caractérisé en ce que chacun desdits moyens de sélection comporte au moins une porte de transfert (123a) activée conformément au signal d'adresse pour appliquer ladite tension de pilotage sur une ligne de mot par l'intermédiaire de la porte de transfert.

11. Appareil selon les revendications 3 à 6, caractérisé en ce que :
chacun desdits moyens de pilotage de ligne de mot comprend :
une pluralité de transistors (100a-100d) dont chacun comporte une borne d'une voie de courant et une grille se voyant appliquer une tension d'alimentation ;
une pluralité de condensateurs (101a-101d) dont chacun comporte une borne connectée à une autre borne de la voie de courant de l'un correspondant desdits transistors ;
une pluralité de moyens de commutation (SW) dont chacun comporte une borne d'entrée se voyant appliquer un signal de synchronisation d'adresse de rangée retardé, une autre borne se voyant appliquer un signal de commutation et une borne de sortie qui est connectée à l'autre borne de chacun desdits condensateurs, ledit moyen de commutation empêchant une opération d'amplification de chacun desdits condensateurs lorsque ledit moyen de commutation reçoit le signal de commutation ;
un circuit de conversion de niveau (114a) agencé dans chacun desdits blocs de réseaux de cellules de mémoire pour convertir un signal de sélection pour sélectionner un bloc de réseaux de cellules de mémoire minimum constitué par une pluralité de lignes de mot selon la tension amplifiée, le signal de sélection présentant un niveau de tension d'alimentation ; et
un circuit de sortie (115a) pour émettre en sortie la tension amplifiée conformément à un signal de sortie en provenance dudit circuit de conversion de niveau.

12. Appareil selon les revendications 3 à 6, caractérisé en ce que ledit premier moyen de sélection comporte au moins une première porte de transfert (223a) activée conformément au signal de sélection pour sélectionner ledit réseau de cellules de mémoire minimum, pour émettre en sortie la tension de pilotage et ledit second moyen de sélection comporte au moins une seconde porte de transfert (123a) activée conformément au signal d'adresse pour émettre en sortie la tension de pilotage appliquée depuis ladite première porte de transfert (223a) sur une ligne de mot.
